# EUROPÄISCHE PATENTANMELDUNG

(11) **EP 3 309 966 A1**
(43) Veröffentlichungstag der Anmeldung: **18.04.2018**
(21) Anmeldenummer: 16194076.2
(22) Anmeldetag: 17.10.2016
(51) Int. Cl.: H03K 17/975

(54) **KAPAZITIVE SCHALT-VORRICHTUNG**

(71) Anmelder: RAFI GmbH & Co. KG, 88276 Berg (DE)
(72) Erfinder: Fleischer, Frank, 88368 Bergatreute (DE)
(74) Vertreter: Engelhardt, Volker

(57) **Zusammenfassung**

Bei einer kapazitiven Schalt-Vorrichtung (1) zur Umwandlung einer manuellen oder mechanischen Zustellbewegung (2) in ein elektrisches Schaltsignal, durch das ein elektrisches Gerät gesteuert ist,
bestehend aus:
- einem Gehäuse (4), in das eine Aufnahmeöffnung (5) eingearbeitet ist,
- einem in der Aufnahmeöffnung (5) des Gehäuses (4) angeordneten Touchscreen (6), der nach außen von einer elektrisch isolierend wirkenden Abdeckplatte (7) und nach innen von einem Display (8) umschlossen ist,
- wobei die Abdeckplatte (7), der Touchscreen (6) und das Display (8) eine Baueinheit (9) bilden, die in der Aufnahmeöffnung (5) des Gehäuses (4) axial beweglich gelagert ist,
- wobei der Touchscreen (6) und das Display (8) mindestens eine kapazitiv betriebene Schaltfläche (10) aufweisen, welche bei der Annäherung eines menschlichen Fingers oder eines mechanischen Zustellgliedes geschaltet wird,
- und aus einer mit der jeweiligen Schaltfläche (10) elektrisch gekoppelten Auswerteelektronik (12), durch die bei einer Veränderung des elektrischen Feldes (23) ein der jeweiligen Schaltfläche (10) entsprechendes Schaltsignal generiert ist, soll unter Beibehaltung der Funktionsweise der Schalt-Vorrichtung (1) eine einfache und kostensparende Herstellung und Montage der Schalt-Vorrichtung (1) mit einer geeigneten Sensor-Anordnung (21) zur Verfügung gestellt sein.

Dies ist dadurch erreicht,
- dass zwischen dem Gehäuse (4) und der Abdeckplatte (7) ein kapazitiv betriebener Sensor (21) vorgesehen ist,
- und dass zwischen dem Sensor (21) und der Abdeckplatte (7) ein Schirm (22) aus einem elektrisch leitfähigen Werkstoff angeordnet ist, durch den der Sensor (21) nach außen kapazitiv isoliert ist und der mit dem Sensor ein gemeinsames elektrisches Feld (23) erzeugt.

## Beschreibung

Die Erfindung bezieht sich auf eine kapazitive Schalt-Vorrichtung zur Umwandlung einer manuellen oder mechanischen Zustellbewegung in ein elektrisches Signal, durch das ein elektrisches Gerät gesteuert ist, nach dem Oberbegriff des Patentanspruches 1.

Aus der WO 2016/016612 A1 kann eine derartige Schalt-Vorrichtung entnommen werden, die zum einem manuelle oder mechanische Zustellbewegungen in entsprechende elektrische Schaltsignale umwandeln kann und die zum anderen auch eine axiale Bewegung des Touchscreen und des Display ermöglicht und diese axiale Bewegung erfasst. Zur Auswertung dieser Bewegung ist umlaufend neben dem Touchscreen und den diese abdeckende Abdeckplatte eine Sensor-Anordnung vorgesehen, die im Wesentlichen aus drei unterschiedlich betriebenen Sensorenelementen besteht. Dabei ist das erste Sensorelement fest mit dem Gehäuse verbunden und dient zur Erzeugung eines elektrischen Feldes. Das erste Sensorelement ist somit elektrisch leitfähig. Das zweite Sensorelement liegt fluchtend oberhalb des ersten Sensorselementes und besteht aus einem elektrisch leitfähigen Werkstoff. Um das von dem ersten Sensorelement erzeugte elektrische Feld nach außen abzuschirmen, ist ein drittes Sensorelement zwischen dem zweiten Sensorelement und der Abdeckplatte anzubringen, so dass das erste und zweite Sensorelement nach außen kapazitiv isoliert sind.

Sobald eine Betätigungskraft auf die Abdeckplatte, den Touchscreen und das Display einwirkt, bewegt sich diese Baueinheit in das Innere des Gehäuses, wodurch der Abstand zwischen dem ersten und dem zweiten Sensorelement reduziert ist, so dass dadurch eine Veränderung des elektrischen Feldes feststellbar ist, die durch eine Auswerteelektronik erfasst ist und in entsprechende elektrische Schaltsignale umgewandelt werden kann. Beispielsweise kann eine solche Sensor-Anordnung dazu verwendet werden, dass der Touchscreen und das Display durch die aufzubringende Betätigungskraft freigeschaltet werden, um erst anschließend überhaupt die Schaltflächen des Touchscreens bedienen zu können.

Die Sensor-Anordnung aus drei unterschiedlichen Sensorelementen ist in nachteiliger Weise bezüglich ihrer Herstellung kostenintensiv und die Ausrichtung der Sensorelemente zueinander ist zeitaufwändig.

Es ist daher Aufgabe der Erfindung, eine Schalt-Vorrichtung der eingangs genannten Gattung derart weiterzubilden, dass unter Beibehaltung der Funktionsweise der Schaltvorrichtung eine einfache und kostensparende Herstellung und Montage der Schaltvorrichtung mit einer geeigneten Sensor-Anordnung zur Verfügung gestellt ist.

Die Aufgabe ist erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Dadurch, dass zwischen dem Gehäuse und der Abdeckplatte mindestens ein kapazitiv betriebener Sensor vorgesehen ist, und dass zwischen dem Sensor und der Abdeckplatte ein Schirm aus einem elektrisch leitfähigen Werkstoff angeordnet ist, durch den der Sensor nach außen kapazitiv isoliert ist und der mit dem Sensor ein gemeinsames elektrisches Feld erzeugt, ist erreicht, dass die Montage der erfindungsgemäßen Schaltvorrichtung schnell und unkompliziert vorgenommen werden kann. Der Schirm kann wie nachfolgend beschrieben als Einbaurahmen ausgestaltet sein. Ebenso kann der Schirm in dem Touchscreen integriert sein, oder auch als äußere Hülle einer Dichtung ausgestaltet sein, die den ersten Sensor trägt.

Die Abschirmung des elektrischen Feldes zwischen dem Sensor und Schirm wird ausschließlich von dem Schirm erreicht, der an der Abdeckplatte anschließt bzw. dem Touchscreen angebracht ist oder der den Sensor, wenn dieser beispielsweise an einer Dichtung freischwingend befestigt ist, ganz oder teilweise ummantelt.

Wenn der kapazitiv betriebene Sensor in der Dichtung aufgehängt oder angebracht ist, bewegt sich dieser sowohl relativ zu dem Gehäuse als auch zu der Abdeckplatte, sobald diese betätigt ist. Aufgrund der Distanzveränderungen zwischen dem Sensor und dem Schirm verändert sich das dazwischen verlaufende elektrische Feld, so dass ein elektrisches Signal generierbar ist, das in Abhängigkeit von der Änderung des elektrischen Feldes steht. Der den Sensor und die Dichtung umschließende oder ummantelnde Körper ist als Schirm ausgestaltet und schirmt demnach den Sensor und das elektrische Feld nach außen, wodurch störende Einflüsse der Umgebung vermieden sind.

Des Weiteren können innerhalb des Schirmes Dichtungselemente oder dgl. vorgesehen sein, um die elektrischen Bauteile im Inneren des Gehäuses vor Feuchtigkeit und anderen Schmutzeintritten von außen zu schützen. Es ist Voraussetzung, dass sowohl der Schirm als auch die Dichtungsmittel elastisch verformbar sind, um die axialen Bewegungen der Abdeckplatte freizugeben. Gleichzeitig dienen die Dichtungen und der Schirm bei Betätigung als Kraftreservoir für die Rückstellung, sobald eine Betätigungskraft auf die Abdeckplatte nicht länger vorliegt.

In der Zeichnung sind vier erfindungsgemäße Ausführungsbeispiele einer Schaltvorrichtung dargestellt, die nachfolgend näher erläutert sind. Im Einzelnen zeigt:
- Figur 1: eine Schaltvorrichtung, die aus einem Gehäuse besteht, in das eine Aufnahmeöffnung eingearbeitet ist und aus einem Touchscreen, der von einer Abdeckplatte nach außen verschlossen ist, die jeweils in der Durchgangsöffnung axial beweglich gelagert sind, in Draufsicht,
- Figur 2a: zwei unterschiedlich ausgestaltete Schaltvorrichtungen gemäß Figur 1, im Schnitt,
- Figur 2b: eine vergrößerte Darstellung der Schaltvorrichtung gemäß Figur 2a, im unbetätigten Zustand,
- Figur 2c: eine vergrößerte Darstellung der Schaltvorrichtung gemäß Figur 2a, im betätigten Zustand,
- Figur 3a: zwei weitere Ausführungsvarianten der Schaltvorrichtung gemäß Figur 1,
- Figur 3b: eine vergrößerte Darstellung der Schaltvorrichtung gemäß Figur 3a, im unbetätigten Zustand und
- Figur 3c: eine vergrößerte Darstellung der Schaltvorrichtung gemäß 3a, im betätigten Zustand.

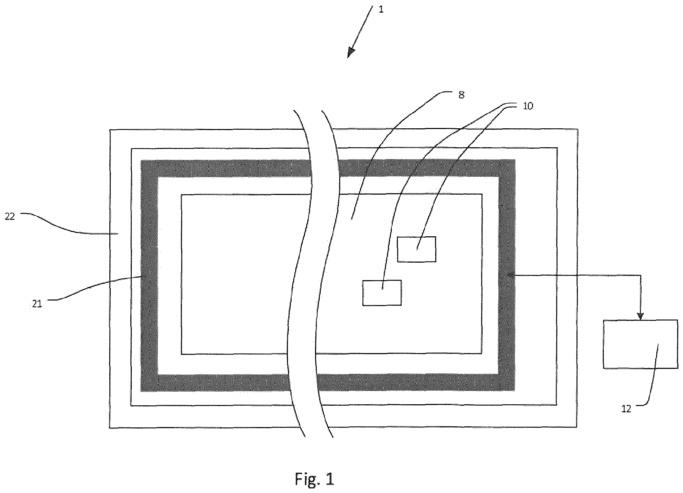

Aus Figur 1 ist eine Schaltvorrichtung 1 zu entnehmen, die aus einem Gehäuse 4 gebildet ist. In das Gehäuse 4 ist eine rechteckförmige Aufnahmeöffnung 5 eingearbeitet, in die ein Touchscreen 6 axial beweglich eingesetzt ist. Der Touchscreen 6 ist nach außen mittels einer Abdeckplatte 7, die beispielsweise aus Glas oder einem biegefesten Kunststoffmaterial hergestellt ist, abgeschirmt. Im Inneren des Gehäuses 4 ist dem Touchscreen 6 ein Display 8 zugeordnet, so dass durch das Display 8 und den Touchscreen 6 eine Vielzahl von Schaltflächen 10 gebildet sind, die beispielsweise von einem menschlichen Finger berührt werden können und somit ein Schaltsignal ausgelöst werden kann. Die jeweiligen Schaltflächen 10 sind elektrisch mit einer Auswerteelektronik 12 gekoppelt, durch die dann anschließend ein elektrisches Gerät, beispielsweise ein Smartphone, eine Werkzeugmaschine oder dgl., betrieben werden kann.

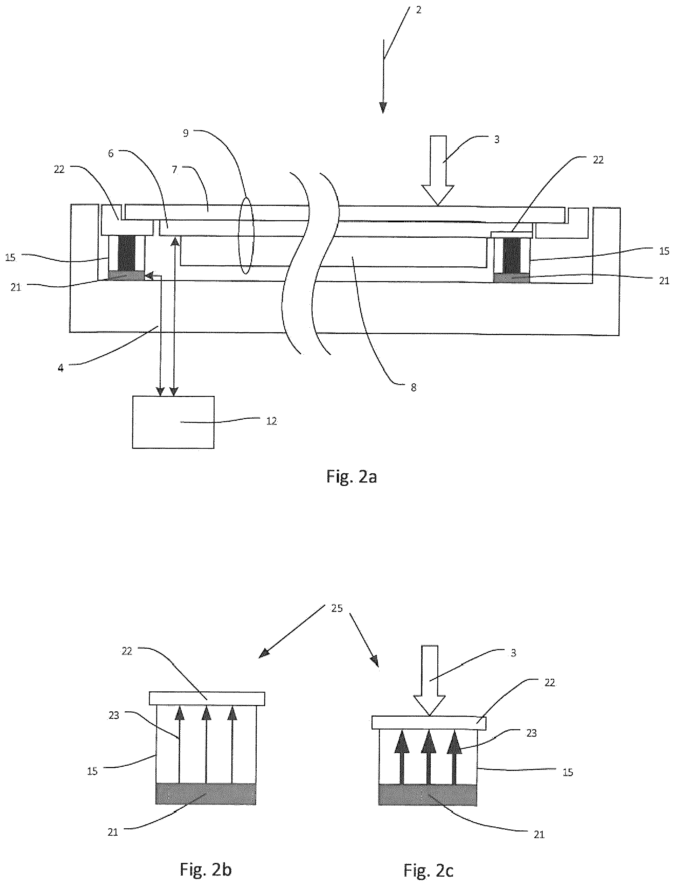

Aus Figur 2a ist ersichtlich, dass die Abdeckplatte 7, der Touchscreen 6 und das Display 8 eine gemeinsame Baueinheit 9 bilden, die beispielsweise durch eine Betätigungskraft 3 in eine axiale Zustellbewegung 2 überführt werden kann. Um die Schaltflächen 10 freizuschalten, ist daher zunächst die Baueinheit 9 axial zu betätigen, um den Einschaltvorgang für die Schaltflächen 10 freizugeben.

In der linken Seite des Gehäuses 4 ist dabei an diesem ein kapazitiv betriebener Sensor 21 angebracht, der demnach ortsfest und als eine Art Rahmen umlaufend um das gesamte Gehäuse im Randbereich der Aufnahmeöffnung 5 angeordnet ist. Auf dem Sensor 21 ist eine Dichtung 15 vorgesehen, die aus einem elastisch verformbaren Werkstoff hergestellt ist und eventuell ein zusätzliches Federelement, welches für die Rückstellung sorgt. Zwischen der Dichtung 15 und der Abdeckplatte 7 ist ein Schirm 22 vorgesehen, der nach Art eines umlaufenden Rahmens zwischen der Abdeckplatte 7 und dem Gehäuse 4 angeordnet ist. Durch den Schirm 22 sollen störende elektrische oder magnetische Einflüsse von außen abgeschirmt sein, so dass ausschließlich das von dem kapazitiv betriebenen Sensor 21 erzeugte Feld zwischen diesem und dem Schirm 22 verläuft.

Auf der rechten Seite des Gehäuses 4 gemäß Figur 2a ist der Schirm 22 als im Querschnitt L-förmiges Bauteil ausgestaltet, das unmittelbar in den Touchscreen 6 oder wahlweise auch in die Abdeckplatte 7 eingesetzt und in diesen ortsfest gehalten sind.

Den Figuren 2b und 2c ist die Veränderung des elektrischen Feldes 23 zwischen dem Sensor 21 und dem Schirm 22 zu entnehmen, sobald auf die Abdeckplatte 7 die Betätigungskraft 3 einwirkt und folglich die Baueinheit 9 die Zustellbewegung 2 vollzieht, wodurch sich der Abstand zwischen dem Sensor 21 und dem Schirm 22 entsprechend verändert. Durch diese Distanzveränderung zwischen dem Sensor 21 und dem Schirm 22 entsteht eine Änderung des elektrischen Feldes, die von der Auswerteelektronik 12 erfasst und demnach in ein elektrisches Signal umgewandelt werden kann.

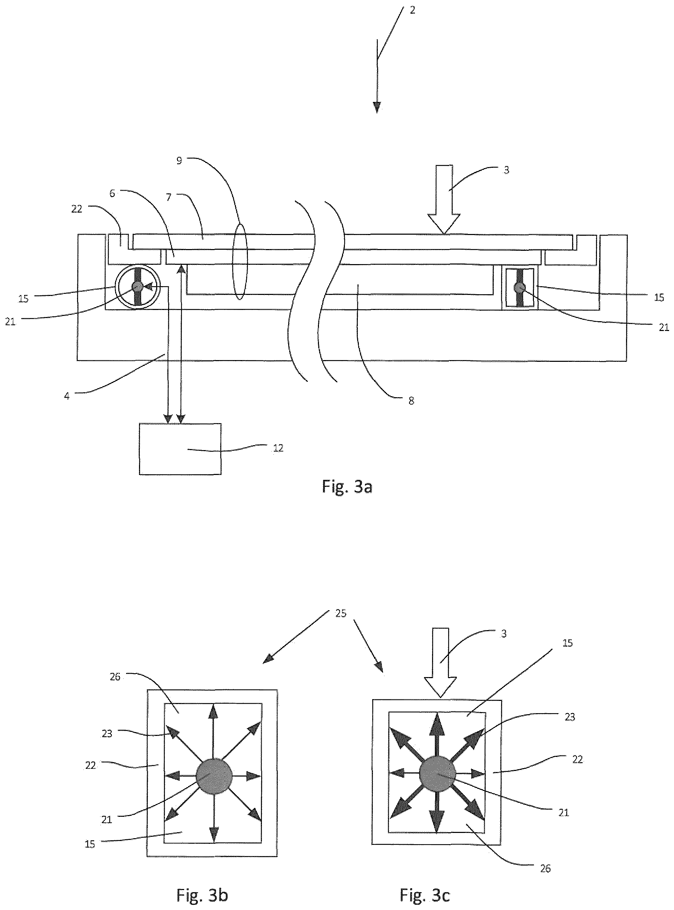

Der Figur 3a ist zu entnehmen, dass der Schirm 22 gemäß der linken Seite des Gehäuses 4 als vollständig geschlossener Zylinder und gemäß der rechten Seite des Gehäuses 4 als rechteckförmiger Körper ausgestaltet sein kann und die Funktion einer Dichtung übernimmt. Darüber hinaus ist der Sensor 21 unmittelbar an der Dichtung 15 im Inneren des Schirms 22 angebracht, so dass bei Betätigung eine schwingende Bewegung des Sensors 21 bezogen auf das Gehäuse 4 und der Baueinheit 9 entsteht. Das elektrische Feld 23 wird demnach von dem Sensor 21 nach außen abgestrahlt und von der Innenwand des zylinder- oder rechteckförmigen Schirmes 22 aufgenommen.

Sobald die Baueinheit 9 durch die Betätigungskraft 3 in die Aufnahmeöffnung 5 des Gehäuses 4 eingedrückt ist, verändert sich die Querschnittsform des jeweiligen dreidimensionalen Schirmes 22 derart, dass der Abstand zwischen dem zentrisch angeordneten Sensor 21 und der Innenwand des jeweiligen Schirmes 22 verändert ist, wodurch das elektrische Feld 23 eine andersartige Charakteristik aufweist, die von der Auswerteelektronik 12 messbar und in entsprechende Steuersignale umwandelbar ist. Der dreidimensionale Schirm 22 besteht aus einem elastisch verformbaren Werkstoff, durch den eine Rückstellkraft, die entgegengesetzt zu der Betätigungskraft 3 wirkt, entsteht und durch die die Baueinheit 9 in ihrer Ausgangslage zurückgedrückt oder zurückgeführt ist, sobald die Betätigungskraft 3 wegfällt.

Im Inneren des dreidimensional ausgestalteten Schirms 22 können Dichtungselemente 26 vorgesehen sein, die das elektrische Feld nicht beeinflussen, da diese keine elektrische oder magnetische Wirkung aufweisen.

Das elektrische Feld 23 weist somit je nach Abstand des Sensors 21 und des Schirmes 22 eine unterschiedliche Charakteristik auf.

Auch der Sensor 21, die Dichtung 15 und der Schirm 22 bilden eine vorgefertigte Baueinheit 25, um die Montage zu erleichtern.

## Patentansprüche

1. Kapazitive Schalt-Vorrichtung (1) zur Umwandlung einer manuellen oder mechanischen Zustellbewegung (2) in ein elektrisches Schaltsignal, durch das ein elektrisches Gerät gesteuert ist,
bestehend aus:
- einem Gehäuse (4), in das eine Aufnahmeöffnung (5) eingearbeitet ist,
- einem in der Aufnahmeöffnung (5) des Gehäuses (4) angeordneten Touchscreen (6), der nach außen von einer elektrisch isolierend wirkenden Abdeckplatte (7) und nach innen von einem Display (8) umschlossen ist,
- wobei die Abdeckplatte (7), der Touchscreen (6) und das Display (8) eine Baueinheit (9) bilden, die in der Aufnahmeöffnung (5) des Gehäuses (4) axial beweglich gelagert ist,
- wobei der Touchscreen (6) und das Display (8) mindestens eine kapazitiv betriebene Schaltfläche (10) aufweisen, welche bei der Annäherung eines menschlichen Fingers oder eines mechanischen Zustellgliedes geschaltet wird,
- und aus einer mit der jeweiligen Schaltfläche (10) elektrisch gekoppelten Auswerteelektronik (12), durch die bei einer Veränderung des elektrischen Feldes (23) ein der jeweiligen Schaltfläche (10) entsprechendes Schaltsignal generiert ist,
**dadurch gekennzeichnet,**
- **dass** zwischen dem Gehäuse (4) und der Abdeckplatte (7) ein kapazitiv betriebener Sensor (21) vorgesehen ist,
- und **dass** zwischen dem Sensor (21) und der Abdeckplatte (7) ein Schirm (22) aus einem elektrisch leitfähigen Werkstoff angeordnet ist, durch den der Sensor (21) nach außen kapazitiv isoliert ist und der mit dem Sensor ein gemeinsames elektrisches Feld (23) erzeugt,

2. Schalt-Vorrichtung nach Anspruch 1,
**dadurch gekennzeichnet,**
**dass** zwischen dem Gehäuse (4) und der Abdeckplatte (7) eine Dichtung (15) vorgesehen ist, durch die eine der Bewegungsrichtung (2) der Betätigungskraft (3) entgegengesetzt wirkende Rückstellkraft erzeugt ist und die aus einem elektrisch nicht-leitfähigen Werkstoff besteht,

3. Schalt-Vorrichtung nach Anspruch 2,
**dadurch gekennzeichnet,**
**dass** der Sensor (21) in der Dichtung (15) angebracht ist und dass der Sensor (21) vor dem Schirm (22) ganz oder teilweise ummantelt ist.

4. Schalt-Vorrichtung nach einem der Ansprüche 2 oder 3,
**dadurch gekennzeichnet,**
**dass** der Schirm (22) und die Dichtung (15) eine gemeinsame Baueinheit (25) bilden und dass der Sensor (21) im Inneren der Baueinheit (25) relativ beweglich zu dem Gehäuse (4) angeordnet ist.

5. Schalt-Vorrichtung nach einem der Ansprüche 2 bis 4,
**dadurch gekennzeichnet,**
**dass** der Schirm (22) während der Zustellbewegung der Baueinheit (9) aus Abdeckplatte (7), Touchscreen (6) und Display (8) elastisch verformbar ist.

6. Schalt-Vorrichtung nach Anspruch 1,
**dadurch gekennzeichnet,**
**dass** der Schirm (22) als Rahmen oder als Platte ausgestaltet ist und dass der Rahmen oder die Platte seitlich neben oder unterhalb der Abdeckplatte (7) oder des Touchscreens (6) unmittelbar fluchtend zu dem Sensor (21) angeordnet ist.

7. Schalt-Vorrichtung nach Anspruch 6,
**dadurch gekennzeichnet,**
**dass** der Schirm (22) an die Kontur der Aufnahmeöffnung (5) des Gehäuses (4) angepasst ist.

8. Schalt-Vorrichtung nach einem der vorgenannten Ansprüche,
**dadurch gekennzeichnet,**
**dass** zwischen dem Sensor (21) und dem Schirm (22) ein Dichtungselement (26) angeordnet ist und dass das Dichtungselement (26) als elastisch verformbare und elektrisch nicht-leitfähige Masse ausgestaltet ist.
